# EUROPEAN PATENT SPECIFICATION

(11) **EP 0 511 702 B1**
(45) Date of publication and mention of the grant of the patent: **19.06.1996**
(21) Application number: 92201102.8
(22) Date of filing: 21.04.1992
(51) Int. Cl.: H01L 23/495

(54) **Semiconductor device encapsulated in resin and completely insulated for high voltages**
Harzverkapselte Halbleiteranordnung und vollständig isoliert für hohe Spannungen
Dispositif semi-conducteur encapsulé en résine et complètement isolé pour hautes tensions

(30) Priority: 26.04.1991 IT CT910010
(43) Date of publication of application: 04.11.1992
(73) Proprietor: CONSORZIO PER LA RICERCA SULLA MICROELETTRONICA NEL MEZZOGIORNO, I-95121 Catania (IT)
(72) Inventor: Mangiagli, Marcantonio, I-95024 Acireale CT (IT); Pogliese, Rosario, I-95030 Gravina di Catania CT (IT)
(74) Representative: Arena, Giovanni

(56) References cited:
- EP-A- 0 098 051
- EP-A- 0 257 681
- EP-A- 0 418 891
- PATENT ABSTRACTS OF JAPAN vol. 012, no. 174 (E-612)24 May 1988 &JP-A-62 282 451
- PATENT ABSTRACTS OF JAPAN vol. 012, no. 435 (E-683)16 November 1988&JP-A-63 169 050

## Description

The present invention relates to a semiconductor device encapsulated in resin and completely insulated for high voltages.

Semiconductor devices encapsulated in resin and completely insulated and capable of resisting voltages up to 1500 V a.c. are know. An example of said devices is illustrated in U.S. patent No. 4,888.307, whose associated FIG. 12 is herein reproduced in FIG. 1.

Said devices are not suited for use in the range of high voltages because in said range they do not comply with international electrical insulation and safety standards.

This is particularly true for very small electrically insulated packages containing semiconductor chips as for example the package known internationally by the designation "TO 220", and other packages of the same dimensions.

In Patent Abstracts of Japan 12(435), (E-683), and JP-A-63169050, an integrated circuit package is described wherein a plurality of leads are alternately bent oppositely to form a zigzag array, thus the plane distance between the leads is reduced while the dielectric breakdown strength is maintained.

In Patent Abstracts of Japan 12(174), (E-612), and JP-A-62282451, a resin sealed semiconductor device is described wherein resin protrusions encircling leads are provided in order to extend the along surface distance between electrodes, so that the dielectric breakdown strength may be improved.

One object of the present invention is to provide a semiconductor device encapsulated in resin and completely insulated. capable of resisting high voltages of at least 2250 V a.c.

In particular the invention proposes to provide devices with the same overall dimensions as the device TO 220 and capable of resisting voltages equal to or greater than 2250 V a.c. while fully complying with applicable international standards.

Another object is to provide a device which be economical, reliable and safe.

The insulated high voltage semiconductor device in accordance with the present invention comprises at least one semiconductor chip encapsulated in a resin body. It also comprises a first face lying in a first plane and adapted for mounting on an external heat dissipator, and a plurality of leads emerging from a second face of said resin body, wherein:
- alternate leads are covered for a certain length by a protrusion of said resin body extending from said second face, the exposed ends of said covered leads lying in a second plane parallel to said first plane and spaced therefrom by a first distance;
- remaining leads are not covered by said protrusions, each of said remaining leads having a first bend and then a second bend in the direction opposite that of the first bend, said first and second bends being separated by a section such that the ends of said uncovered leads lie in a third plane parallel to said first and second planes at a distance from said first plane greater than said first distance, whereby the minimum distance in air between ends of adjacent leads ensures an insulation voltage of 2250 V alternating current;
- the length (L) of said protrusion covering said alternate leads is selected such that the shortest distance between exposed parts of adjacent leads along the surface of the package and the minimum distance in air between exposed portions of said covered leads nearest said resin coating and adjacent uncovered leads between said first and second bends ensure an insulation voltage of 2250 V alternating current.

To further clarify the innovative principles of the present invention and its advantages as compared with the known art, possible embodiments applying said principles are described below as nonlimiting examples, with the aid of the annexed drawings.

In the drawings:

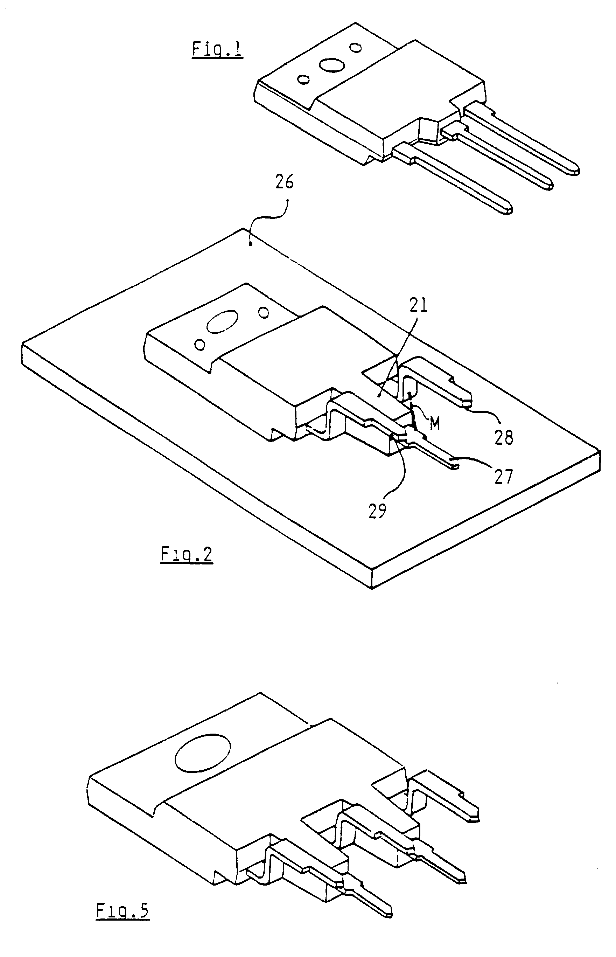

- FIG. 1: shows an perspective view not in scale of an electrically insulated plastic power transistor in accordance with the known art,
- FIG.2: shows an perspective view not in scale of an electrically insulated plastic device for high voltages in accordance with the present invention placed in contact on a dissipator,
- FIG.3: shows a plan view not in scale of the device shown in FIG. 2,
- FIG.4: shows a cross section view not in scale of the device shown in FIG. 2,
- FIG.5: shows an perspective view not in scale of another plastic device in accordance with the present invention, and
- FIG.6: shows a cross section view not in scale of the device shown in FIG. 2 in accordance with a variant which calls for a heat-dissipating plate incorporated in the package.

FIGS.2, 3 and 4 show perspective, plan and cross-section views respectively not in scale of an electrically insulated device for high voltages in accordance with the present invention.

The characteristics which distinguish primarily said device concern the particular shape of the leads 28 and 29 and the resin coating 21 of the central lead.

As regards the shape of the leads it is observed that they follow each other with their terminal part in staggered position, the terminal part of a lead lying on a horizontal plane different from that on which lies the terminal part of the immediately preceding or immediately following lead. This occurs because the external leads 28 and 29 display near the plastic covering two bends almost at right angle which have their terminal parts on a plane parallel to the dissipator 26 and at a distance therefrom greater than the distance which the plane of lying of the terminal part of the lead 27 displays toward said dissipator.

The distance between said two planes. i.e. the two right-angle bends of a same side terminal, is selected such that the distance between the end of the central lead and the end of the side leads is not less than the limit which the standards impose on the clearance distance for the maximum insulation voltage which the device must withstand; the clearance distance is defined as the minimum distance in air between two conducting elements, i.e. between close leads and between leads and the external dissipator.

As concerns the coating 21 of the central lead, which is made of the same molding resin and during the mold transfer process, its length L (FIG. 3) must meet primarily the following two dimensioning criteria.

In accordance with a first criterion the length L must be such as to ensure that the minimum distance M in air between the central lead section nearest the coating 21 and the side lead sections between the two consecutive bends be not less that said clearance distance. In this manner the clearance distance imposed by the standards is complied with for every part of two adjacent leads, i.e. not only between their ends but also between the initial uncovered section of the central lead and the bend of the side leads.

In accordance with another criterion the length L must also be such as to ensure a creepage distance between the central lead and the adjacent leads not less than that imposed by the standards. The creepage distance is the shortest path between two leads or between a lead and the external dissipator measured along the surface of the package. In the case of FIG. 3 the creepage distance between the lead 27 and the lead 29 is N = e+f+g.

Since the minimum distances between the two side leads measured in air and along the surface of the package are also not less than the clearance and creepage distances respectively called for by the standards for the reference voltage, with the above dimensioning the clearance and creepage distances between any lead and the others is fully complied with.

In the case of a device with the same overall dimensions as TO 220, the length L is 6 mm and allows clearance and creepage distances between the central lead and adjacent leads of 5.3 mm and 7.4 mm respectively.

Therefore said length L together with the particular conformation of the side leads allows clearance distances M and creepage distances N between the leads not less that those (3.0 mm and 3.2 mm respectively) called for by the standards for a voltage of 2250 V a.c. As regards the clearance and creepage distances of the leads in relation to the external dissipator 26 (distances P and Q = a+b+c, see FIG. 4) compliance with the standard values is achieved by appropriately selecting the values of P and b; indeed in the sum a+b+c the a+c part is not variable when P has been set.

In the case of a device with overall dimensions the same as TO 220, the distance P is set at 3.1 mm and the distance b at 1.2 mm so as to fully comply with the aforesaid values of 3.0 mm and 3.2 mm respectively prescribed by the standards for the clearance and creepage distances which the leads must meet for the external dissipator also.

In the embodiment example described above reference was made to creepage and clearance values which permit an electrical insulation of 2250 V in alternating current. However, it is clear that the general criteria of dimensioning indicated are applicable also when it is intended to ensure greater insulation voltages.

In the example of FIG. 2 the device rests on the external dissipator 26 and is electrically insulated therefrom also. But if installation of the device does not require said dissipator because the device can be mounted in free air, the device can withstand greater insulation voltages than those indicated above. The clearance and creepage distances of 5.3 mm and 7.4 mm respectively in the example described ensure an electrical insulation of 2800 V a.c. which is thus higher that the 4.2 mm and 5.0 mm called for by the standards for said voltage.

In conclusion, the above mentioned inventive characteristics taken together make it possible to provide an encapsulated semiconductor device completely insulated in resin and suitable for containing at least one bipolar transistor chip or other similar semiconductor devices and withstand higher voltages for given overall dimensions than conventional devices.

Although a single form of execution of the present invention has been illustrated and described it is clear that numerous variations and modifications can be made thereto without going beyond the scope of said invention.

Indeed, the solution described is not necessarily limited to a device with 3 terminals but can be extended to devices with more than 3 leads such as for example with 5 terminals, e.g. suitable for containing an integrated circuit such as that shown in FIG. 5, the dimensioning criteria indicated for the 3-terminal device being easily extended to devices with more than three terminals.

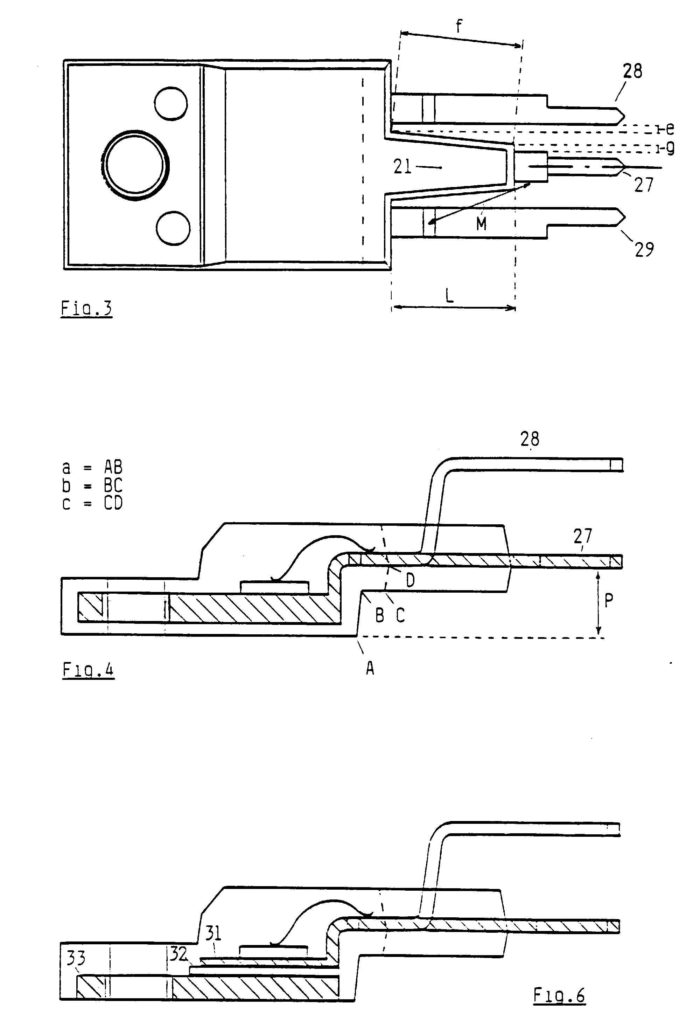

In addition the encapsulated resin device, instead of appearing in cross section as in FIG. 4, could appear as in FIG. 6, i.e. with the copper plate 31 (on which is directly welded the chip) welded by means of an insulating layer 32 (consisting of Al₂O₃, AlN, resin, etc.) to a copper plate 33 acting as a dissipator incorporated in the package, to be placed optionally in contact with another external dissipating plate.

## Claims

1. An insulated high voltage semiconductor device comprising at least one semiconductor chip encapsulated in a resin body (21), said device comprising a first face lying in a first plane and being adapted for mounting on an external heat dissipator, and a plurality of leads (27, 28, 29) emerging from a second face of said resin body, wherein:
- alternate leads (27) are covered for a certain length by a protrusion of said resin body extending from said second face, the exposed ends of said covered leads lying in a second olane parallel to said first plane and spaced therefrom by a first distance (P);
- remaining leads (28, 29) are not covered by said protrusions, each of said remaining leads having a first bend and then a second bend in the direction opposite that of the first bend, said first and second bends being separated by a section such that the ends of said uncovered leads lie in a third plane parallel to said first and second planes at a distance from said first plane greater than said first distance (P), whereby the minimum distance in air between ends of adjacent leads ensures an insulation voltage of 2250 V alternating current;
- the length (L) of said protrusion covering said alternate leads is selected such that the shortest distance between exposed parts of adjacent leads along the surface of the package and the minimum distance in air (M) between exposed portions of said covered leads nearest said resin coating and adjacent uncovered leads between said first and second bends ensure an insulation voltage of 2250 V alternating current.

2. A semiconductor device for high voltages as set forth in claim 1 characterized in that said bends form an angle of approximately 90°.

## Patentansprüche

1. Isolierte Hochspannungshalbleitervorrichtung mit mindestens einem in einem Harzkörper (21) verkapselten Halbleiterchip, wobei die Vorrichtung eine erste Fläche enthält, die in einer ersten Ebene liegt und zum Anbringen einer externen Wärmeabstrahleinrichtung geeignet ist, und einer Anzahl von Leitern (27, 28, 29), die von einer zweiten Fläche des Harzkörpers ausgehen, bei der:
- abwechselnde Leiter (27) über eine bestimmte Länge von einem Vorsprung des Harzkörpers bedeckt sind, der sich von der zweiten Fläche erstreckt, wobei die freiliegenden Enden der bedeckten Leiter in einer zweiten Ebene liegen, die zu der ersten Ebene parallel und davon um eine erste Entfernung (P) beabstandet ist;
- verbleibende Leiter (28, 29) nicht von den Vorsprüngen bedeckt sind, wobei jeder der verbleibenden Leiter eine erste Biegung und dann eine zweite Biegung in der zu der der ersten Biegung entgegengesetzten Richtung aufweist, wobei die ersten und zweiten Biegungen durch einen Abschnitt so getrennt sind, daß die Enden der unbedeckten Leiter in einer dritten Ebene liegen, die zu den ersten und zweiten Ebenen in einer Entfernung von der ersten Ebene parallel ist, die größer als die erste Entfernung (P) ist, wobei die Minimumentfernung in der Luft zwischen Enden benachbarter Leiter eine Isolationsspannung von 2250 V Wechselstrom sicherstellt;
- die Länge (L) des die abwechselnden Leiter bedeckenden Vorsprungs so gewählt ist, daß die kürzeste Entfernung zwischen freiliegenden Teilen benachbarter Leiter entlang der Oberfläche des Gehäuses und die Minimumentfernung in der Luft (M) zwischen freiliegenden Bereichen der bedeckten Leitern, die der Harzbeschichtung am nächsten sind, und benachbarten unbedeckten Leitern zwischen den ersten und zweiten Biegungen eine Isolationsspannung von 2250 V Wechselstrom sicherstellen.

2. Halbleitervorrichtung für hohe Spannungen nach Anspruch 1, dadurch gekennzeichnet, daß die Biegungen einen Winkel von ungefähr 90° bilden.

## Revendications

1. Dispositif semiconducteur haute tension isolé comprenant au moins une puce semiconductrice encapsulée dans un corps de résine (21), ce dispositif ayant une première face se trouvant dans un premier plan et étant adapté au montage d'un dissipateur thermique externe, et une pluralité de conducteurs (27, 28, 29) sortant d'une seconde face du corps de résine, dans lequel :
des conducteurs alternés (27) sont recouverts sur une certaine longueur d'une saillie du corps de résine s'étendant à partir de la seconde face, les extrémités exposées des conducteurs recouverts se trouvant dans un second plan parallèle au premier plan et espacé de celui-ci d'une première distance (P) ;
les conducteurs restants (28, 29) ne sont pas recouverts par lesdites saillies, chacun des conducteurs restants ayant une première courbure puis une seconde courbure dans la direction opposée à celle de la première courbure, les première et seconde courbures étant séparées par une portion telle que les extrémités des conducteurs non-recouverts se trouvent dans un troisième plan parallèle aux premier et second plans à une distance du premier plan supérieure à la première distance (P), d'où il résulte que la distance minimale dans l'air entre les extrémités de conducteurs adjacents assure une tension d'isolement de 2250 volts alternatifs ;
la longueur (L) de la saillie recouvrant les conducteurs alternés est choisie telle que la plus courte distance entre les parties exposées des conducteurs adjacents le long de la surface du boîtier et la distance minimale dans l'air (M) entre les parties exposées des conducteurs recouverts les plus proches du revêtement de résine et voisines des conducteurs non-recouverts entre les première et seconde courbures assure une tension d'isolement de 2250 volts alternatifs.

2. Dispositif semiconducteur haute tension selon la revendication 1, caractérisé en ce que lesdites courbures forment un angle d'environ 90°.
